# EUROPÄISCHE PATENTSCHRIFT

(11) **EP 2 883 427 B1**
(45) Veröffentlichungstag und Bekanntmachung des Hinweises auf die Patenterteilung: **28.09.2016**
(21) Anmeldenummer: 12753436.0
(22) Anmeldetag: 10.08.2012
(51) Int. Cl.: H05K 1/02, H01H 85/046, H02H 3/02, H01H 89/06

(54) **VORRICHTUNG ZUM ANSCHLIESSEN AN EIN STROMNETZ SOWIE VERFAHREN ZUM SCHUTZ EINER DERARTIGEN VORRICHTUNG**
DEVICE FOR CONNECTING TO A POWER NETWORK AND METHOD FOR PROTECTING SUCH A DEVICE
DISPOSITIF DE RACCORDEMENT À UN RÉSEAU ÉLECTRIQUE ET PROCÉDÉ DE PROTECTION D'UN TEL DISPOSITIF

(43) Veröffentlichungstag der Anmeldung: 17.06.2015
(73) Patentinhaber: Siemens Aktiengesellschaft, 80333 München (DE)
(72) Erfinder: HERTZ, Dirk, 92260 Fichtenhof (DE); JONAS, Stephan, 92431 Neunburg (DE); REICHENBACH, Norbert, 92224 Amberg (DE); SEITZ, Johann, 92224 Amberg (DE)
(86) Internationale Anmeldenummer: PCT/EP2012/065709
(87) Internationale Veröffentlichungsnummer: WO 2014/023357

(56) Entgegenhaltungen:
- EP-A1- 1 544 974
- EP-A1- 2 429 267
- GB-A- 1 237 312

## Beschreibung

Die Erfindung betrifft eine Vorrichtung zum Anschließen an ein Stromnetz sowie ein Verfahren zum Schutz einer derartigen Vorrichtung. Die Vorrichtung umfasst eine Leiterplatte, eine erste eingangsseitige Anschlussstelle, an welche eine erste Phase des Stromnetzes anschließbar ist, eine zweite eingangsseitige Anschlussstelle, an welche eine zweite Phase des Stromnetzes anschließbar ist, und einen ersten und zweiten elektrischen Leiter, wobei der erste Leiter mit der ersten eingangsseitigen Anschlussstelle und der zweite Leiter mit der zweiten eingangsseitigen Anschlussstelle geräteintern verbunden ist.

Das Stromnetz ist insbesondere ein Niederspannungsnetz einer industriellen Anlage über welches ein Dreiphasenwechselstrom zu einem Verbraucher geführt wird. Der Verbraucher ist insbesondere eine elektrische Maschine, z.B. ein Elektromotor.

In derartigen elektrischen Anlagen werden üblicherweise aktiv Strom beeinflussende Geräte zum Schalten, Steuern und/oder Regeln vom elektrischen Strom eingesetzt. Dies können z.B. mechanische und/oder elektronische Schaltgeräte zum Betreiben von Asynchronmotoren oder ohmschen Lasten, aber auch Umrichter zum drehzahlveränderlichen Betrieb von Motoren sein. Ebenso können dies z.B. Wechselrichter zum Einspeisen von regenerativ erzeugtem Strom in das Stromnetz sein.

Hierzu werden die aktiv Strom beeinflussenden Geräte über deren eingangsseitige Anschlussstellen mit Leitungen des Stromnetzes verbunden und mittels deren ausgangsseitigen Anschlussstellen mit Leitungen des elektrischen Verbrauchers bzw. einer Energie erzeugenden Einheit verbunden. Während des Betriebs der Anlagen kann es, wenn auch in der Regel nur sehr selten, zu Kurzschlüssen zwischen den Leitungen oder innerhalb des angeschlossenen Verbrauchers bzw. der Energie erzeugenden Einheit kommen.

Die im Kurzschlussfall fließenden Ströme können sehr hoch sein und ohne zusätzliche Maßnahmen eine Zerstörung der aktiv Strom beeinflussenden Geräte, der Leitungen und der Verbraucher bzw. Energie erzeugenden Einheiten verursachen.

Um eine mit der Zerstörung der Anlagenteile verbundene Gefährdung von Mensch und Umwelt zu verhindern, werden üblicherweise vor das aktiv Strom beeinflussende Gerät geeignete Überstromschutzeinrichtung geschaltet, die den Kurzschlussstrom ausreichend schnell abschalten. Eine Überstromschutzeinrichtung ist beispielsweise ein Leitungsschutzschalter. Detektiert ein Leitungsschutzschalter einen Kurzschlussstrom am Stromnetz, so kann er die Energieversorgung für die dem Leitungsschutzschalter über den Versorgungsstrang nachgeschaltete Geräte unterbrechen.

Die beim Kurzschluss entstehenden sehr hohen Ströme fließen vom Generator über das Stromnetz zur Kurzschlussstelle und werden von der Überstromschutzeinrichtung sehr schnell ausgeschaltet. Für die Dauer des Kurzschlusses werden alle Leitungen und Geräte, über die der Kurzschlussstrom fließt, übermäßig stark und teilweise zerstörerisch belastet. Die Zerstörung innerhalb von Geräten entsteht auch auf Leiterplatten, wenn über diese der Kurzschluss-Strom fließt, durch das Verdampfen der Leiterbahnen oder Teilen von Bauteilen und den dadurch entstehenden Lichtbogen und das leitfähige Plasma.

Die Höhe des Kurzschlussstromes wird durch die Impedanz des Stromkreises und den Phasenwinkel im Moment seiner Entstehung bestimmt. In Abhängigkeit vom Kurzschlussstrom werden die betroffenen Geräte zerstört.

Im Bereich der industriellen Automatisierungstechnik wird daher bei der Projektierung von Anlagen darauf geachtet, dass am Einbauort der Geräte der maximal mögliche Kurzschlussstrom nicht größer sein kann als der prospektive Kurzschlussstrom, mit dem die Geräte geprüft wurden, und dass den Geräten Überstromschutzeinrichtungen vorgeschaltet sind, mit denen diese Prüfung durchgeführt wurde oder Überstromschutzeinrichtungen verwendet werden, die bei diesem prospektivem Kurzschlussstrom eine geringere Zerstörenergie im Gerät entstehen lassen als mit der geprüften Überstromschutzeinrichtungen. Bei der Wahl der Überstromschutzeinrichtungen wird unterschieden zwischen der Art der Absicherung.

Bei Absicherung nach Zuordnungsart 1 dürfen die Geräte nach dem Kurzschluss defekt sein, es dürfen aber keine elektrisch leitfähigen Teile des Gerätes berührbar sein. Bei Absicherung nach Zuordnungsart 2 bleibt das Gerät unbeschädigt und kann nach dem Austausch bzw. Rücksetzen der Überstromschutzeinrichtungen wieder betrieben werden.

Da die Absicherung nach Zuordnungsart 2 teurere Überstromschutzeinrichtungen erfordert, wird auf Grund der Seltenheit von Kurzschlüssen häufig nur die kostengünstigere und einfachere Absicherung nach Zuordnungsart 1 gewählt.

Da die am Einbauort der Anlage maximal mögliche Kurzschlussstromhöhe oft nicht genau bekannt ist oder erst relativ aufwändig vom Projekteur berechnet werden muss, werden vom Projekteur Geräte bevorzugt, die bei der einfacheren Absicherung nach Zuordnungsart 1 in Kombination mit einer üblichen Überstromschutzeinrichtung einen möglichst hohen, maximal möglichen Kurzschlussstrom am Einbauort zulassen. Auf diese Weise erübrigen sich die normalerweise aufwändigen Berechnungen bezüglich der maximal möglichen Kurzschlussstromhöhe und der Projektierungsaufwand für die Anlage sinkt deutlich.

Dokumente EP 1 544 974, EP 2 429 267 und GB 1 237 312 offenbaren einschlägigen Stand der Technik.

Es ist Aufgabe der vorliegenden Erfindung eine möglichst kompakte Vorrichtung, bei welcher mindestens zwei Phasen eines Stromnetzes über eine Leiterplatte geführt werden, bereitzustellen, welche einen möglichst hohen Kurzschlussstrom, insbesondere gemäß Zuordnungsart 1, zulässt.

Diese Aufgabe wird gelöst durch eine Vorrichtung gemäß Anspruch 1, d.h. durch eine Vorrichtung bei welcher der erste Leiter als Leiterbahn in einer Innenlage der Leiterplatte geführt ist und dort eine Verjüngung aufweist, wobei die Verjüngung derart ausgebildet ist und der zweite Leiter derart an der Verjüngung des ersten Leiters vorbeigeführt ist, dass eine zwischen der Verjüngung des ersten Leiters und dem zweiten Leiter vorliegende elektrische Isolation bei einem Kurzschlussstrom über den ersten Leiter zerstört wird, so dass eine elektrisch leitende Verbindung zwischen dem ersten und zweiten Leiter vorliegt, und ein Verfahren gemäß Anspruch 15, d.h. durch ein Verfahren zum Schutz einer Vorrichtung nach einem der Ansprüche 1 bis 13, wobei der zweite Leiter zur Verjüngung des ersten Leiters elektrisch isoliert ist und bei einem Kurzschlussstrom über den ersten Leiter eine zwischen der Verjüngung des ersten Leiters und dem zweiten Leiter vorliegende elektrische Isolation zerstört wird, so dass eine elektrisch leitende Verbindung zwischen dem ersten und zweiten Leiter vorliegt.

Vorteilhafte Weiterbildungen der Erfindung sind in den abhängigen Ansprüchen 2 bis 14 angegeben.

Der mit der Erfindung erzielte Vorteil besteht insbesondere darin, dass eine kompakte Vorrichtung bereitgestellt werden kann, welche bei einer Prüfung auf die Zuordnungsart 1 einen hohen zulässigen Kurzschlussstrom erreicht.

Der zulässige Kurzschlussstrom der Vorrichtung gemäß Zuordnungsart 1 führt insbesondere nicht zu einer unzulässigen Beschädigung der Vorrichtung. Eine Zerstörung wird als unzulässig bewertet, wenn das Gehäuse der Vorrichtung derart beschädigt wird, dass innere, elektrische leitfähige Teile von außen berührbar sind. Ferner ist ein Wegfliegen mechanischer Teile von der Vorrichtung unerwünscht.

Bei dem betrachteten Kurzschlussstrom für die Vorrichtung handelt es sich stets um den für die Vorrichtung zulässigen Kurzschlussstrom, insbesondere gemäß Zuordnungsart 1.

Das Stromnetz ist vorzugsweise ein Niederspannungsnetz, insbesondere einer industriellen Anlage. Das Stromnetz ist insbesondere ein Dreiphasenwechselstromnetz.

Die Vorrichtung umfasst ein Gehäuse, in welchem sich die Leiterplatte und der erste und zweite Leiter befinden. Die eingangsseitigen ersten und zweiten Anschlussstellen sind vorzugsweise derart am Gehäuse angeordnet, dass sie von außen zugänglich sind, so dass jeweils eine externe Leitung über die Anschlussstelle mit dem geräteinternen Leiter verbunden werden kann.

Über den ersten und zweiten Leiter wird die Energieversorgung zu einem Verbraucher geführt. Mittels der Vorrichtung kann vorzugsweise die über die Leiter erfolgende Energiezufuhr für den Verbraucher gesteuert werden. Der Verbraucher kann in der Vorrichtung sein oder ist der Vorrichtung nachgeschaltet. Der Verbraucher ist insbesondere ein elektrischer Verbraucher, z.B. ein Elektromotor.

Im aktiven Betrieb der Vorrichtung liegt zwischen dem ersten und zweiten Leiter vorzugsweise ein Potentialunterschied vor.

Der erste Leiter weist in seiner in der Innenlage der Leiterplatte geführten Leiterbahn die Verjüngung auf; d.h. die Verjüngung wird vollständig von der Leiterplatte umschlossen.

Im normalen Betriebszustand der Vorrichtung, d.h. über den ersten Leiter fließt ein ordnungsgemäßer Betriebsstrom, ist die zweite Leitung elektrisch isoliert zur ersten Leitung. Im Bereich der Verjüngung erfolgt dies insbesondere durch die Leiterplatte.

Bei Geräten mit Leiterplatten, bei welchen der Strom über an der Außenseite der Leiterplatte befindliche Leiterbahnen geführt wird, verursacht ein Kurzschlussstrom üblicherweise ein schlagartiges Verdampfen von Teilen der Leiterplatte. Durch die sehr schnell erhitzte und sich ausdehnende Luft entsteht eine Druckwirkung, die das Gerätegehäuse bis zur unzulässigen mechanischen Zerstörung beanspruchen kann. Ferner können durch das entstehende leitfähige Plasma weitere Kurzschlusspfade innerhalb des Geräts erzeugt werden, die den Kurzschlussstrom und die Schadwirkung noch weiter vergrößern.

Erfolgt das Verdampfen der Leiterbahn hingegen in einer Innenlage der Leiterplatte und ist die Leiterbahn entsprechend schmal bemessen, kann die Zerstörwirkung, die durch das Verdampfen des metallischen Leiters und des unmittelbar anliegenden Leiterplattenmaterials entsteht, drastisch reduziert werden. Dadurch, dass die Verjüngung in der Innenlagen der Leiterplatte geführt ist beschränkt sich die Zerstörung auf das Innere der Leiterplatte und tritt nicht oder nur mit geringer Wirkung nach außen.

Liegt ein für die Vorrichtung zulässiger Kurzschluss vor, so dass ein zulässiger Kurzschlussstrom über den ersten Leiter fließt, so wird der erste Leiter gezielt an seiner Verjüngung thermisch erwärmt. Diese thermische Belastung führt dazu, dass die vorliegende elektrische Isolation zwischen dem zweiten Leiter und der Verjüngung des ersten Leiters zerstört wird, so dass der erste Leiter im Bereich der Verjüngung für den Kurschlussstrom eine elektrisch leitende Verbindung zum zweiten Leiter herstellt. Vorzugsweise wird durch die thermische Belastung ein Teil der Leiterplatte zwischen der Verjüngung und dem zweiten Leiter verdampft. Es liegt folglich eine elektrisch leitende Verbindung zwischen dem ersten und zweiten Leiter vor, so dass der Kurzschlussstrom gezielt über den ersten und zweiten Leiter fließen kann. Der so künstlich hergestellte Hilfskurzschlussstrompfad erzeugt definierte Kurzschlussverhältnisse und führt so zu einer zuverlässigen Unterbrechung der Stromzufuhr zum Gerät durch die Aktivierung einer vorgeschalteten Überstromschutzeinrichtung.

Durch die Verjüngung des ersten Leiters und dem nebengeordneten zweiten Leiter kann bei einem Kurschlussstrom über den ersten Leiter gezielt ein Hilfskurzschluss innerhalb der Vorrichtung erzeugt werden, so dass nachgelagerte Bauteile der Vorrichtung durch den Kurschlussstrom nicht belastet werden. Durch die Platzierung der Verjüngung innerhalb der Vorrichtung kann gezielt der Ort des Hilfskurzschlussstrompfades und somit der zu erwartenden Zerstörung auf der ersten Leiterplatte durch einen Kurzschlussstrom bestimmt werden. Die Bestückung der Leiterplatte kann daher entsprechend gestaltet werden, so dass die durch einen zulässigen Kurzschlussstrom herbeigeführte Zerstörung nicht zu einer unzulässigen Zerstörung führt.

Die Verjüngung des ersten Leiters ist vorzugsweise zu Beginn des ersten Leiters in der Leiterplatte angeordnet, so dass die durch einen zulässigen Kurschlussstrom entstehende thermische Belastung gezielt in den vorderen Bereich der Leiterplatte gelenkt wird, so dass der Verjüngung nachgeschaltete Komponenten auf der Leiterplatte nicht bzw. kaum beschädigt werden.

Die Verjüngung ist somit derart ausgebildet und der zweite Leiter ist gegenüber der Verjüngung des ersten Leiters derart angeordnet, dass die durch einen zulässigen Kurzschlussstrom über der ersten Leitung verursachte thermische Belastung an der Verjüngung des ersten Leiters dazu führt, dass für den Kurzschlussstrom die elektrische Isolation zwischen der Verjüngung des ersten Leiters und dem zweiten Leiter nicht mehr gegeben ist.

Bei einem zulässigen Kurzschlussstrom über der ersten Leitung wird somit beabsichtigt für den Kurzschlussstrom eine elektrische Verbindung zwischen der ersten und zweiten Leitung im Bereich der Verjüngung erzeugt. Hierdurch kann eine Vorrichtung bereitgestellt werden, welche kompakt ausgebildet ist und ferner in Hinblick auf die Zuordnungsart 1 optimiert ausgebildet ist.

Die in der Innenlage der Leiterplatte geführte Leiterbahn des ersten Leiters im Bereich der Verjüngung ist vorzugsweise orthogonal zum vorbei geführten zweiten Leiter und/oder zu den Durchkontaktierungen der Leiterplatte ausgerichtet. Die Leiterbahn des ersten Leiters in der Innenlage der Leiterplatte und/oder die Längsachse der Verjüngung des ersten Leiters sind insbesondere parallel zur größten Seitenfläche der Leiterplatte ausgerichtet.

Der erste Leiter wird vorzugsweise lediglich teilweise als Leiterbahn in der Innenlage der Leiterplatte geführt. Der erste Leiter kann beispielsweise zur Kontaktierung mit einem auf der Leiterplatte angeordneten Bauteil auf die Außenseite der Leiterplatte geführt sein. Ebenso ist es denkbar, dass der erste Leiter kurz nach der Verjüngung auf die Außenseite der Leiterplatte geführt ist und dort verläuft.

Bei einem zulässigen Kurzschlussstrom über den ersten Leiter kommt es vorzugsweise zu einer irreversiblen Zerstörung im Inneren der Vorrichtung, so dass dennoch die Anforderungen der Zuordnungsart 1 erfüllt werden.

Der an der Verjüngung des ersten Leiters vorbei geführte zweite Leiter kann beispielsweise über eine Durchkontaktierung der Leiterplatte an der Verjüngung des ersten Leiters vorbeigeführt sein.

Es ist ebenso denkbar, dass der zweite Leiter ebenfalls als Leiterbahn eine in der Innenlage angeordnete Verjüngung aufweist und mit dieser an der Verjüngung des ersten Leiters vorbeigeführt ist. Hierdurch würde ein Kurzschlussstrom über der ersten oder zweiten Leiter zu einem Hilfskurzschlussstrompfad zwischen den Verjüngungen des ersten und zweiten Leiters führen.

In einer vorteilhaften Ausführungsform der Erfindung weist die Vorrichtung eine erste und eine zweite ausgangsseitige Anschlussstelle auf, wobei der erste Leiter eine geräteinterne elektrische Verbindung zwischen der ersten eingangsseitigen Anschlussstelle und der ersten ausgangsseitigen Anschlussstelle herstellt und der zweite Leiter eine geräteinterne elektrische Verbindung zwischen der zweiten eingangsseitigen Anschlussstelle und der zweiten ausgangsseitigen Anschlussstelle herstellt. Im aktiven Betrieb der Vorrichtung kann eine elektrisch leitende Verbindung zwischen den eingangsseitigen und ausgangsseitigen Anschlussstellen vorliegen.

In einer weiteren vorteilhaften Ausführungsform der Erfindung umfasst der erste Leiter ein Schaltelement. Vorzugsweise umfasst der zweite Leiter ebenso ein Schaltelement. Das Schaltelement ist insbesondere ein elektromechanisches Schaltelement und/oder ein Halbleiterschaltelement.

Die Vorrichtung ist somit ein Schaltgerät, mittels welchem die elektrisch leitende Verbindung zwischen der eingangsseitigen und ausgangsseitigen Anschlussstelle gesteuert werden kann.

In einer weiteren vorteilhaften Ausführungsform der Erfindung befindet sich die Verjüngung des ersten Leiters zwischen der ersten Anschlussstelle und dem Schaltelement.

In einer weiteren vorteilhaften Ausführungsform der Erfindung befindet sich die Verjüngung des ersten Leiters im Bereich der ersten 20 Prozent der gesamten Länge des ersten Leiters auf der Leiterplatte.

Die Leiterplatte weist einen eingangseitigen Anschluss zum Anschließen des ersten Leiters und einen ausgangsseitigen Anschluss zum Freigeben des ersten Leiters auf.

Die gesamte Länge des ersten Leiters auf der Leiterplatte ist die Länge des ersten Leiters vom eingangseitigen Anschluss bis zum ausgangsseitigen Anschluss der Leiterplatte.

Der erste Leiter wird vorzugsweise direkt vom eingangseitigen Anschluss der Leiterplatte als Leiterbahn in der Innenlage der Leiterplatte geführt.

Die Verjüngung der Leiterbahn des ersten Leiters erfolgt vorzugsweise bevor der erste Leiter das erste Mal die Innenlage der Leiterplatte verlässt.

Die Verjüngung des ersten Leiters erfolgt vorzugsweise bevor die Leiterbahn des ersten Leiters ein auf der Leiterplatte montiertes Bauteil (z.B. Schaltelement) kontaktiert.

In einer weiteren vorteilhaften Ausführungsform der Erfindung weist die Verjüngung des ersten Leiters eine Länge von maximal 5 Prozent der gesamten Länge des ersten Leiters auf der Leiterplatte auf.

In einer weiteren vorteilhaften Ausführungsform der Erfindung ist der zweite Leiter über eine Durchkontaktierung der Leiterplatte an der Verjüngung des ersten Leiters vorbeigeführt. Der zweite Leiter wird folglich durch ein Kontaktloch in der Leiterplatte an der Verjüngung des ersten Leiters vorbeigeführt. Das Kontaktloch der Leiterplatte weist vorzugsweise eine Hülse auf. Die Hülse ist vorzugsweise metallisiert. Die durch den Kurzschluss an der Verjüngung des ersten Leiters auftretende mechanische Belastung der Leiterplatte entsteht somit an einem mechanisch durch die Hülse stabilisierten Bereich der Leiterplatte.

In einer weiteren vorteilhaften Ausführungsform der Erfindung ist der erste Leiter aufgeteilt, so dass zwei oder mehrere Verjüngungen des ersten Leiters vorliegen. Es liegen somit mindestens zwei nebengeordnete Verjüngungen vor.

Durch das Aufteilen des Leiters kann die bei normalem Betrieb entstehende Verlustleistung auf eine größere Fläche aufgeteilt werden. Zusätzlich kann die durch den Kurzschlussstrom hervorgerufene Krafteinwirkung auf die Verjüngungen optimiert auf die Leiterplatte verteilt werden, so dass ein optimiertes Zerstören der elektrischen Isolation zum benachbarten zweiten Leiter bei einem Kurzschlussstrom über den ersten Leiter erzielt wird.

Die Verjüngungen des aufgeteilten Leiters werden vorzugsweise parallel zueinander innerhalb der Leiterplatte geführt.

Der zweite Leiter wird vorzugsweise zwischen zwei Verjüngungen des ersten Leiters vorbeigeführt.

In einer weiteren vorteilhaften Ausführungsform der Erfindung sind die zwei Verjüngungen des ersten Leiters derart zueinander angeordnet, dass eine zwischen den Verjüngungen durch die Leiterplatte vorliegende elektrische Isolation bei einem zulässigen Kurzschlussstrom über den ersten Leiter zerstört wird.

Die Verjüngungen werden mittels der Leiterplatte voneinander elektrisch isoliert. Fließt ein zulässiger Kurzschlussstrom über den ersten Leiter, so wird die Leiterplatte gezielt an der Engstelle zwischen den Verjüngungen derart thermisch belastet, dass die elektrische Isolation für den Kurzschlussstrom nicht mehr gegeben ist und der Hilfskurzschlussstrompfad entsteht.

In einer weiteren vorteilhaften Ausführungsform der Erfindung umfasst die Vorrichtung eine dritte eingangsseitige Anschlussstelle, an welche eine dritte Phase eines Stromnetzes anschließbar ist, und einen dritten elektrischen Leiter, wobei der dritte Leiter mit der dritten eingangsseitigen Anschlussstelle geräteintern verbunden ist, wobei der dritte Leiter als Leiterbahn in der Innenlage der Leiterplatte geführt ist und dort eine Verjüngung aufweist, wobei die Verjüngung des dritten Leiters derart ausgebildet ist und der zweite und/oder erste Leiter derart an der Verjüngung des dritten Leiters vorbeigeführt ist, dass eine zwischen der Verjüngung des dritten Leiters und dem zweiten und/oder ersten Leiter vorliegende elektrische Isolation bei einem zulässigen Kurzschlussstrom über den dritten Leiter zerstört wird, so dass eine elektrisch leitende Verbindung zwischen dem dritten Leiter und dem zweiten und/oder ersten Leiter, insbesondere für den Kurschlussstrom, vorliegt.

Der Aufbau des dritten Leiters, insbesondere bezüglich der Verjüngung des dritten Leiters, kann analog zum Aufbau des ersten Leiters erfolgen. Ferner kann die Anordnung der Verjüngung des dritten Leiters gegenüber dem zweiten und/oder ersten Leiter analog zur Anordnung der Verjüngung des ersten Leiters gegenüber dem zweiten Leiter erfolgen.

Der dritte Leiter kann beispielsweise mit seiner Verjüngung an der Verjüngung des ersten Leiters vorbeigeführt sein, so dass sich bei einem Kurzschlussstrom über den ersten oder dritten Leiter ein Hilfskurzschlussstrompfad zwischen den Verjüngungen des ersten und dritten Leiters bildet.

In einer weiteren vorteilhaften Ausführungsform der Erfindung ist der zweite Leiter über dieselbe Durchkontaktierung der Leiterplatte an der Verjüngung des ersten und dritten Leiters vorbeigeführt.

In einer weiteren vorteilhaften Ausführungsform der Erfindung ist der dritte Leiter an der Verjüngung des ersten Leiters oder einer weiteren Verjüngung des ersten Leiters in einer Innenlage der Leiterplatte derart vorbeigeführt, dass eine zwischen der Verjüngung bzw. weiteren Verjüngung des ersten Leiters und dem dritten Leiter vorliegende elektrische Isolation bei einem zulässigen Kurzschlussstrom über den ersten Leiter zerstört wird, so dass eine elektrisch leitende Verbindung zwischen dem ersten und dritten Leiter, insbesondere für den Kurzschlussstrom, vorliegt.

Der dritte Leiter kann beispielsweise über eine Durchkontaktierung der Leiterplatte an der Verjüngung des ersten Leiters vorbeigeführt sein.

In einer weiteren vorteilhaften Ausführungsform der Erfindung weist der dritte Leiter in der Innenlage der Leiterplatte eine weitere Verjüngung auf, wobei die weitere Verjüngung des dritten Leiters derart ausgebildet ist und der erste Leiter derart an der weiteren Verjüngung des dritten Leiters vorbeigeführt ist, dass eine zwischen der weiteren Verjüngung des dritten Leiters und dem zweiten oder ersten Leiter vorliegende elektrische Isolation bei einem zulässigen Kurzschlussstrom über den dritten Leiter zerstört wird, so dass eine elektrisch leitende Verbindung zwischen dem dritten Leiter und zweiten oder ersten Leiter, insbesondere für den Kurschlussstrom, vorliegt.

Die beiden Verjüngungen des dritten Leiters sind über dessen Längserstreckung räumlich beabstandet. Es handelt sich somit nicht um nebengeordnete Verjüngungen, welche entstehen, sofern der dritte Leiter aufgeteilt wird.

In einer weiteren vorteilhaften Ausführungsform der Erfindung ist der zweite Leiter als Leiterbahn in der Innenlage der Leiterplatte geführt und weist dort eine Verjüngung auf, wobei die Verjüngung des zweiten Leiters derart ausgebildet ist und der erste Leiter derart an der Verjüngung des zweiten Leiters vorbeigeführt ist, dass eine zwischen der Verjüngung des zweiten Leiters und dem ersten Leiter vorliegende elektrische Isolation bei einem Kurzschlussstrom über den zweiten Leiter zerstört wird, so dass eine elektrisch leitende Verbindung zwischen dem zweiten und ersten Leiter, insbesondere für den Kurschlussstrom, vorliegt.

Der Aufbau des zweiten Leiters, insbesondere dessen Verjüngung, kann analog zum Aufbau des ersten Leiter erfolgen. Ebenso kann die Anordnung der Verjüngung des zweiten Leiters gegenüber dem ersten Leiter analog zur Anordnung der Verjüngung des ersten Leiters gegenüber dem zweiten Leiter erfolgen.

Der zweite Leiter kann beispielsweise mit seiner Verjüngung an der Verjüngung des ersten Leiters vorbeigeführt sein, so dass sich bei einem Kurzschlussstrom über den ersten oder zweiten Leiter ein Hilfskurzschlussstrompfad zwischen den Verjüngungen des ersten und zweiten Leiters bildet.

Vorzugsweise ist der dritte Leiter an derselben Verjüngung des zweiten Leiters oder einer weiteren in der Innenlage der Leiterplatte angeordneten Verjüngung des zweiten Leiters derart vorbeigeführt, dass eine zwischen der Verjüngung bzw. weiteren Verjüngung des zweiten Leiters und dem dritten Leiter vorliegende elektrische Isolation bei einem Kurzschlussstrom über den zweiten Leiter zerstört wird, so dass eine elektrisch leitende Verbindung zwischen dem zweiten und dritten Leiter, insbesondere für den Kurschlussstrom, vorliegt.

Die strombedingte thermische Belastung des ersten, zweiten und/oder dritten Leiters ist vorzugsweise an seiner Verjüngung in der Innenlage der Leiterplatte innerhalb des Motorstarters 1 am höchsten. Die bei einem zulässigen Kurschlussstrom entstehende Krafteinwirkung auf die Vorrichtung wird hierdurch gezielt zu der entsprechenden Verjüngung des Leiters gelenkt, so dass innerhalb der Vorrichtung ein Hilfskurzschlussstrompfad zu mindestens einem benachbarten Leiter entsteht.

Die Vorrichtung ist vorzugsweise ein elektrisches Gerät für die industrielle Automatisierungstechnik. Die Vorrichtung ist insbesondere ein aktiv Strom beeinflussendes Gerät zum Schalten, Steuern und/oder Regeln von einem über das Gerät geführten elektrischen Strom. Vorzugsweise ist die Vorrichtung ein mechanisches, elektronisches und/oder elektromechanisches Schaltgerät, ein Umrichter oder ein Wechselrichter.

Vorzugsweise lässt die Vorrichtung nach Zuordnungsart 1 einen maximal zulässigen Kurzschlussstrom von bis zu 55 kA über den ersten, zweiten und/oder dritten Leiter zu.

In einer weiteren vorteilhaften Ausführungsform der Erfindung liegt ein System einer industriellen Anlage vor. Das System umfasst eine Vorrichtung nach einem der Ansprüche 1 bis 13, eine Überstromschutzeinrichtung, einen elektrischen Verbraucher und ein Stromnetz der industriellen Anlage. Das Stromnetz ist über die Vorrichtung mit dem Verbraucher verbunden. Zwischen der Vorrichtung und dem Stromnetz ist die Überstromschutzeinrichtung zwischengeschaltet, so dass durch ihn eine Überwachung des Stromnetzes auf einen Kurzschluss erfolgt. Die Überstromschutzeinrichtung ist insbesondere ein Leitungsschutzschalter oder ein Leistungsschalter.

Im Folgenden werden die Erfindung und Ausgestaltungen der Erfindung anhand der in den Figuren dargestellten Ausführungsbeispiele näher beschrieben und erläutert. Es zeigen:
- FIG 1: eine schematische Darstellung einer industriellen Anlage mit einem Verbraucher welcher an ein Stromnetz angebunden ist,
- FIG 2: eine schematische Darstellung der Anordnung des ersten, zweiten und dritten Leiters innerhalb eines Teils der Leiterplatte 2 der Vorrichtung gemäß FIG 1,
- FIG 3: eine schematische Darstellung der Anordnung gemäß FIG 2 nachdem über den ersten Leiter ein Kurzschlussstrom geflossen ist,
- FIG 4: eine Draufsicht eines Schnittbildes eines Teils der Leiterplatte 2 einer Vorrichtung gemäß FIG 1, und
- FIG 5: eine weitere Draufsicht eines Schnittbildes eines Teils der Leiterplatte 2 einer Vorrichtung gemäß FIG 1.

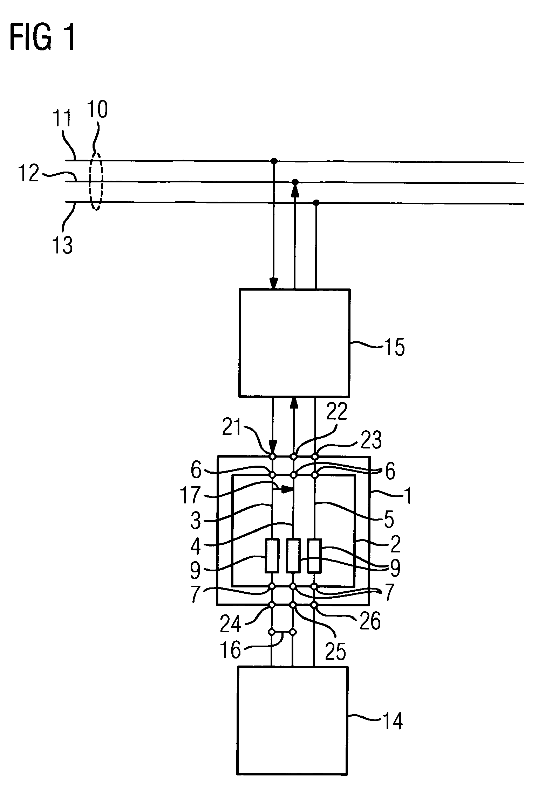

FIG 1 zeigt eine schematische Darstellung einer industriellen Anlage mit einem Verbraucher 14, welcher an ein Stromnetz 10 angebunden ist. Das Stromnetz 10 ist ein Niederspannungsnetz 10 der industriellen Anlage. Das Niederspannungsnetz umfasst eine erste Phase 11, eine zweite Phase 12 und eine dritte Phase 13. Der Verbraucher 14 ist eine elektrische Maschine, z.B. ein Elektromotor.

Die Anbindung des Verbrauchers 14 an den Dreiphasenwechselstrom des Niederspannungsnetzes 10 erfolgt über eine Überstromschutzeinrichtung 15 und einer Vorrichtung 1. Die Überstromschutzeinrichtung 15 ist in diesem Ausführungsbeispiel ein Leitungsschutzschalter. Sie kann jedoch ebenso z.B. ein Leistungsschalter oder Motorschutzschalter sein.

Die drei Phasen 11,12,13 des Stromnetzes 10 werden über den Leitungsschutzschalter zum Verbraucher 1 geführt. Der Leitungsschutzschalter 15 kann bei Vorliegen eines Kurzschlusses in den Energieversorgungssträngen (den Phasen) zum Verbraucher 14 die Energiezufuhr zum Verbraucher 14 unterbrechen. Der Leitungsschutzschalter 15 ist ein wieder verwendbares, nicht selbsttätig rückstellendes Sicherungsgerät.

Die Vorrichtung 1 ist ein Motorstarter 1, mittels welchem die Energiezufuhr zum elektrischen Verbraucher 14 gesteuert werden kann. Mittels des Motorstarters 1 kann insbesondere ein Sanftstarten und/oder Sanftstoppen des Verbrauchers 14 erfolgen. Der Motorstarter 1 umfasst eine erste eingangsseitige Anschlussstelle 21, an welche die erste Phase 11 des Stromnetzes 10 angeschlossen ist, eine zweite eingangsseitige Anschlussstelle 22, an welche die zweite Phase 12 des Stromnetzes 10 angeschlossen ist, eine dritte eingangsseitige Anschlussstelle 23, an welche die dritte Phase 13 des Stromnetzes 10 angeschlossen ist, einen ersten Leiter 3, welcher in Abhängigkeit der Schaltstellung eines zwischengeschalteten Schaltelements 9 eine elektrisch leitende Verbindung zur ersten ausgangseitigen Anschlussstelle 24 herstellt, einen zweiten Leiter 4, welcher in Abhängigkeit der Schaltstellung eines zwischengeschalteten Schaltelements 9 eine elektrisch leitende Verbindung zur zweiten ausgangseitigen Anschlussstelle 25 herstellt, einen dritten Leiter 5, welcher in Abhängigkeit der Schaltstellung eines zwischengeschalteten Schaltelements 9 eine elektrisch leitende Verbindung zur dritten ausgangseitigen Anschlussstelle 26 herstellt, und eine Leiterplatte 2, in welcher der erste, zweite und dritte Leiter 3,4,5 teilweise als Leiterbahn in einer Innenlage der Leiterplatte 2 geführt wird. Die Verbindung der ersten, zweiten und dritten Leitung 3,4,5 mit der Leiterplatte 2 erfolgt jeweils mittels eines eingangseitigen Anschlusses 6 und eines ausgangsseitigen Anschlusses 7 der Leiterplatte 2.

Mittels des Motorstarters 1 kann der nachgeschaltete Verbraucher 14 ein- und ausgeschaltet werden. Hierbei kann mittels des Motorstarters 1 das Einschalten und Ausschalten des Verbrauchers gezielt gesteuert werden, so dass ein Sanftanlauf bzw. Sanftauslauf am Verbraucher 14 erfolgt. Zum Steuern der Energiezufuhr des Verbrauchers 12 umfasst der Motorstarter 1 je Leitung 3,4,5 das Schaltelement 9, welches auf der Leiterplatte 2 montiert ist. Das Schaltelement 9 ist jeweils ein elektromechanisches Schaltelement, welches als Bypass-Schaltung ein Halbleiterschaltelement aufweist.

Die ausgangseitigen Anschlussstellen 24,25,26 sind mittels Leitungen mit dem Verbraucher 14 verbunden, so dass der Verbraucher mit dem Stromnetz 10, insbesondere mit dessen Phasen 11,12,13 verbunden ist. Der Verbraucher ist somit mit drei Versorgungssträngen mit dem Stromnetz 10 verbunden. Ein erster Versorgungsstrang verbindet den Verbraucher 14 über den Motorstarter 1 und dem Leitungsschutzschalter 15 mit der ersten Phase 11 des Stromnetzes 10. Ein zweiter Versorgungsstrang verbindet den Verbraucher 14 über den Motorstarter 1 und dem Leitungsschutzschalter 15 mit der zweiten Phase 12 des Stromnetzes 10. Ein dritter Versorgungsstrang verbindet den Verbraucher 14 über den Motorstarter 1 und dem Leitungsschutzschalter 15 mit der dritten Phase 12 des Stromnetzes 10.

Der erste Leiter 3 des Motorstarters 1 wird über seinen eingangsseitigen Anschluss 6 der Leiterplatte 2 als Leiterbahn in der Innenlage der Leiterplatte 2 geführt. Bevor der erste Leiter 3 über ein auf der Leiterplatte 2 montiertes elektrisches Bauteil (z.B. das Schaltelement 9) geführt wird, wird die Leiterbahn des ersten Leiters 3 verjüngt. In diesem Ausführungsbeispiel wird die Leiterbahn des ersten Leiters 3 aufgeteilt, so dass drei Verjüngungen entstehen. An der Verjüngung ist die strombedingte thermische Belastung des ersten Leiters 3 innerhalb des Motorstarters 1 am höchsten.

Der zweite Leiter 4 des Motorstarters 1 wird ebenso über seinen eingangseitigen Anschluss 6 der Leiterplatte 2 als Leiterbahn in der Innenlage der Leiterplatte 2 geführt. Bevor der zweite Leiter 4 über ein auf der Leiterplatte 2 montiertes elektrisches Bauteil (z.B. das Schaltelement 9) geführt wird, wird die Leiterbahn des zweiten Leiters 4 verjüngt. An der Verjüngung ist die strombedingte thermische Belastung des zweiten Leiters 4 innerhalb des Motorstarters 1 am höchsten.

Der dritte Leiter 4 des Motorstarters 1 wird ebenso über seinen eingangseitigen Anschluss 6 der Leiterplatte 2 als Leiterbahn in der Innenlage der Leiterplatte 2 geführt. Bevor der dritte Leiter 4 über ein auf der Leiterplatte 2 montiertes elektrisches Bauteil (z.B. das Schaltelement 9) geführt wird, wird die Leiterbahn des dritten Leiters 5 verjüngt. In diesem Ausführungsbeispiel wird die Leiterbahn des dritten Leiters 5 aufgeteilt, so dass drei Verjüngungen entstehen. An der Verjüngung ist die strombedingte thermische Belastung des dritten Leiters 5 innerhalb des Motorstarters 1 am höchsten.

Der erste Leiter 3 ist über eine Durchkontaktierung der Leiterplatte 2 an einer Verjüngung des zweiten und dritten Leiters 4,5 vorbeigeführt.

Der zweite Leiter 4 ist über eine Durchkontaktierung der Leiterplatte 2 an einer Verjüngung des ersten und dritten Leiters 3,5 vorbeigeführt.

Der dritte Leiter 5 ist über eine Durchkontaktierung der Leiterplatte 2 an einer Verjüngung des ersten und zweiten Leiters 3,4 vorbeigeführt.

Im ordnungsgemäßen Betriebszustand sind der erste Leiter 3 vom zweiten und dritten Leiter 4,5 sowie der zweite Leiter 4 vom dritten Leiter 5 elektrisch isoliert. Die Verjüngungen der einzelnen Leiter 3,4,5 sind durch die Leiterplatte 2 von den benachbarten Leitern 3,4,5 elektrisch isoliert.

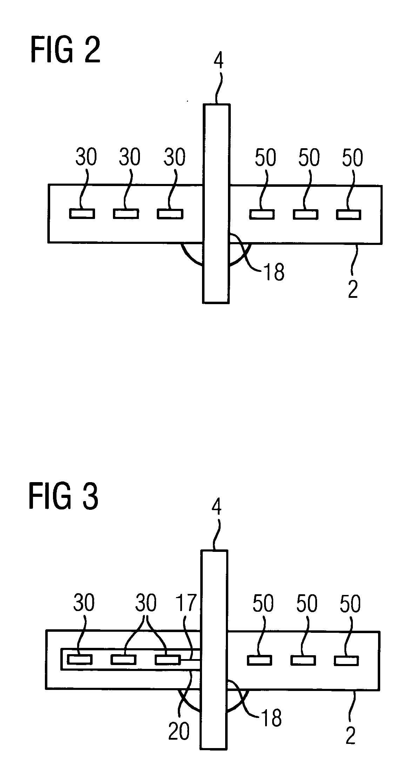

FIG 2 zeigt eine schematische Darstellung der Anordnung des ersten, zweiten und dritten Leiters 3,4,5 innerhalb eines Teils der Leiterplatte 2 der Vorrichtung gemäß FIG 1. Es ist der Querschnitt der Leiterplatte 2 kurz nach den eingangsseitigen Anschlüssen 6 der Leiterplatte 2 abgebildet, wobei drei Verjüngungen 30 der Leiterbahn des ersten Leiters 3, der über eine Durchkontaktierung 18 der Leiterplatte 2 geführte zweite Leiter 4 und die drei Verjüngungen 50 der Leiterbahn des dritten Leiters 5 zu sehen sind.

Die Verjüngungen 30 des erste Leiters sind derart ausgebildet und der zweite Leiter 4 ist derart an einer der Verjüngungen 30 des ersten Leiters 3 vorbeigeführt, dass eine zwischen den Verjüngungen 30 des ersten Leiters 3 und dem zweiten Leiter 4 vorliegende elektrische Isolation bei einem zulässigen Kurzschlussstrom über den ersten Leiter zerstört wird, so dass eine elektrisch leitende Verbindung für den Kurzschlussstrom zwischen dem ersten und zweiten Leiter 3,4 vorliegt.

Die Verjüngungen 50 des dritten Leiters 3 sind derart ausgebildet und der zweite Leiter 4 ist derart an einer der Verjüngung 50 des dritten Leiters 3 vorbeigeführt, dass eine zwischen den Verjüngungen 50 des dritten Leiters 5 und dem zweiten Leiter 4 vorliegende elektrische Isolation bei einem zulässigen Kurzschlussstrom über den dritten Leiter 5 zerstört wird, so dass eine elektrisch leitende Verbindung für den Kurzschlussstrom zwischen dem dritten und zweiten Leiter 4 vorliegt.

Kommt es nun wie in der FIG 1 durch den Anlagenkurzschlussstrompfad 16 dargestellt, zu einem Anlagenkurzschluss zwischen dem ersten und zweiten Versorgungsstrang im Bereich der Verbindung des Motorstarters 1 mit dem Verbraucher 14, so wird mit einem zeitlichen Verzug zum Anlagenkurzschluss der Leitungsschutzschalter 15 ausgelöst und unterbricht die Stromzufuhr zum Verbraucher 14.

Während dieser Zeit fließt ein erhöhter Kurzschlussstrom über den ersten und zweiten Versorgungsstrang (anhand der Pfeile beim Versorgungsstrang angedeutet), so dass eine erhöhte Belastung für die Geräte und insbesondere deren Bauteile und Komponenten vorliegt, welche zwischen dem Stromnetz und dem Anlagenkurzschluss zwischengeschaltet sind und im ersten und zweiten Versorgungsstrang liegen. Es tritt somit für den Motorstarter, insbesondere für seine erste und zweite Leitung und die mit ihr verbundenen Komponenten und Bauteile, eine erhöhte Belastung auf. Über die erste Leitung 6 des Motorstarters 1 fließt folglich der Kurzschlussstrom.

Durch den über den ersten Leiter 3 fließenden Kurzschlussstrom kommt es nun beabsichtigt an der Verjüngung 30 des ersten Leiters 3 zu einem derartigen kurzschlussstrombedingten Temperaturanstieg, dass angrenzende Teile 20 der Leitplatte 2 verdampfen und/oder derart zerstört werden, so dass deren elektrische Isolation derart vermindert wird, dass, wie in der FIG 1 und 3 dargestellt, ein Hilfskurzschlussstrompfad 17 zwischen der ersten und zweiten Leitung 3,4 entsteht.

Die ansonsten vorliegende elektrische Isolation zwischen den Verjüngungen 30 des ersten Leiters 3 und dem zweiten Leiter 4 wird bewusst durch die thermische Auswirkung des Kurzschlussstroms auf die Verjüngungen 30 des ersten Leiters 3 zerstört, so dass für den Kurzschlussstrom eine elektrisch leitende Verbindung zwischen dem ersten und zweiten Leiter 4 vorliegt. Ein Hilfskurzschlussstrompfad 17 wird gebildet. Der Kurzschlussstrom kann folglich über den zweiten Leiter 3 entweichen. Dies ist in der FIG 1 und 3 durch den Hilfskurzschlussstrompfad 17 dargestellt.

Der durch einen Kurzschluss verursachte Schaden kann somit gezielt in einen Bereich der Vorrichtung 1 verlagert werden, in welchem mit einem geringeren Schaden zu rechnen ist. Da die einzelnen Leiter 3,4,5 über die Leiterplatte geführt werden, sind die Verjüngungen der einzelnen Leiter in der Nähe der eingangsseitigen Anschlüsse 6 der Leiterplatte 2 angeordnet, so dass eine Beschädigung von auf der Leiterplatte nachgeschalteten Komponenten, welche mit den Leitern 3,4,5 in Kontakt stehen, vermieden wird.

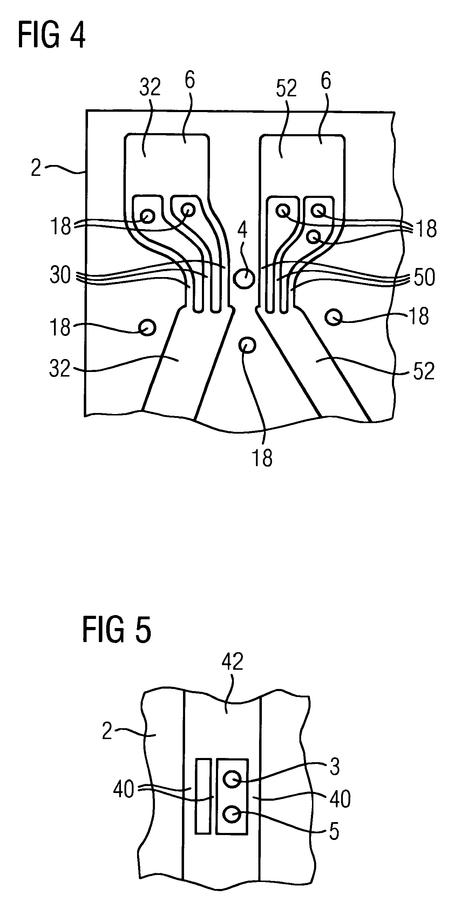

FIG 4 zeigt eine Draufsicht eines Schnittbildes eines Teils der Leiterplatte 2 einer Vorrichtung gemäß FIG 1. Die dargestellte Anordnung der FIG 4 umfasst den in der FIG 2 gezeigten Querschnitt der Leiterplatte 2.

Es ist die Innenlage der Leiterplatte 2 dargestellt, in welcher die Leiterbahn 32 des ersten Leiters 3 und die Leiterbahn 52 des dritten Leiters 5 geführt ist. Ferner sind Durchkontaktierungen 18 der Leiterplatte 2 und der zweite Leiter 4, welcher über eine Durchkontaktierung der Leiterplatte 2 geführt ist, dargestellt.

Der erste Leiter wird über den eingangseitigen Anschluss 6 der Leiterplatte 2 unmittelbar als Leiterbahn 32 innerhalb der Innenlage der Leiterplatte 2 geführt. Bevor der erste Leiter ein auf der Leiterplatte 2 montiertes Bauteil kontaktiert, wird die Leiterbahn 32 des ersten Leiters aufgeteilt, so dass drei Verjüngungen 30 entstehen.

Der dritte Leiter wird über den eingangseitigen Anschluss 6 der Leiterplatte 2 unmittelbar als Leiterbahn 52 innerhalb der Innenlage der Leiterplatte 2 geführt. Bevor der dritte Leiter ein auf der Leiterplatte 2 montiertes Bauteil kontaktiert, wird die Leiterbahn 52 des dritten Leiters aufgeteilt, so dass drei Verjüngungen 30 entstehen.

Die Verjüngungen 30 der Leiterbahn 32 des ersten Leiters und der über die Durchkontaktierung der Leiterplatte 2 geführte zweite Leiter 4 werden gezielt derart angeordnet, dass bei einem zulässigen Kurzschlussstrom über die Leiterbahn 32 des ersten Leiters die durch die Leiterplatte 2 vorliegende elektrische Isolation zwischen der Verjüngung 30 des ersten Leiters und dem zweiten Leiter 4 zerstört wird, so dass ein Hilfskurzschlussstrompfad entsteht.

Die Verjüngungen 50 der Leiterbahn 52 des dritten Leiters und der über die Durchkontaktierung der Leiterplatte 2 geführte zweite Leiter 4 werden gezielt derart angeordnet, dass bei einem zulässigen Kurzschlussstrom über die Leiterbahn 52 des dritten Leiters die durch die Leiterplatte 2 vorliegende elektrische Isolation zwischen der Verjüngung 50 des dritten Leiters und dem zweiten Leiter 4 zerstört wird, so dass ein Hilfskurzschlussstrompfad entsteht.

Die Leiterplatte 2 weist im Bereich der Verjüngungen 30,50 der ersten und dritten Leiterbahn 32,52 Durchkontaktierungen 18 auf, so dass die Leiterplatte 2 in diesem Bereich eine erhöhte mechanische Stabilität aufweist.

FIG 5 zeigt eine weitere Draufsicht eines Schnittbildes eines Teils der Leiterplatte 2 einer Vorrichtung gemäß FIG 1. Es ist die Innenlage der Leiterplatte 2 dargestellt, in welcher die Leiterbahn 42 des zweiten Leiters geführt ist. Ferner sind der erste und dritte Leiter 3,5 jeweils über eine Durchkontaktierung der Leiterplatte 2 zwischen zwei Verjüngungen 40 des zweiten Leiters vorbeigeführt.

Der zweite Leiter wird als Leiterbahn 42 innerhalb der Innenlage der Leiterplatte 2 geführt. Bevor der zweite Leiter ein auf der Leiterplatte 2 montiertes Bauteil (z.B. das Schaltelement) kontaktiert, wird die Leiterbahn 42 des zweiten Leiters aufgeteilt, so dass drei Verjüngungen 40 entstehen.

Zwei der Verjüngungen 40 der Leiterbahn 32 des zweiten Leiters sowie die über die Durchkontaktierung der Leiterplatte 2 geführten ersten und dritten Leiter 3,5 werden gezielt derart angeordnet, dass bei einem zulässigen Kurzschlussstrom über die Leiterbahn 42 des zweiten Leiters die durch die Leiterplatte 2 vorliegende elektrische Isolation zwischen den Verjüngungen 40 des zweiten Leiters 4 und dem ersten und dritten Leiter 3,5 zerstört wird, so dass ein Hilfskurzschlussstrompfad entsteht.

Ein Kurzschluss am Ausgang 24,25,26 der Vorrichtung 1, an den an dessen Ausgang 24,25,26 angeschlossenen Leitungen oder im Verbraucher 14 bzw. der Energie erzeugenden Einheiten erzeugt innerhalb des Verbrauchers 1 gezielt einen oder mehrere Hilfskurzschlussstrompfade 17 zu mindestens einer weiteren Phase. Der Hilfskurzschlussstrompfad 17 ist so beschaffen, dass ein vorgegebener, maximal möglicher Kurzschlussstrom (z.B. 50 kA) von einem vorgeschalteten Leitungsschutzschalter abgeschaltet werden kann, ohne dass es zu einer unzulässigen Zerstörung der Vorrichtung 1 gemäß Zuordnungsart 1 kommt.

Der bevorzugte Ort für den Hilfskurzschlussstrompfad 17 und somit für die Verjüngungen 30,40,50 der einzelnen Leiterbahnen 32,42,52 der Leiter 3,4,5 ist Nahe seiner eingangsseitigen Anschlussstelle 21,22,23, da nach dem Ansprechen des Hilfskurzschlussstrompfads 17 der verbleibende durch die Vorrichtung zu den ausgangseitigen Anschlussstellen 24,25,26 hindurch fließende Kurzschlussstrom erheblich reduziert wird, so dass durch ihn nur noch eine geringe Schadenswirkung in der gesamten Vorrichtung 1 entwickelt werden kann.

Nach dem eingangsseitigen Anschluss 6 der Leiter an der Leiterplatte 2 werden die Leiterbahnen 32,42,52 in mehrere Verjüngungen 30,40,50 aufgeteilt. Diese müssen aufgrund von Verlusten möglichst kurz sein. Diese Verjüngungen 30,40,50 befinden sich in den Innenlagen der Leiterplatte 2 und werden um Durchkontaktierungen 18 mindestens eines anderen Leiters 3,4,5 herumgeführt. Dieser Aufbau erfolgt gleichermaßen für alle drei Phasen und somit Leiter 3,4,5. Dies führt bei einem Kurzschluss dazu, dass die Engstellen der betroffenen Leiterbahn 32,42,52 zwischen den Verjüngungen 30,40,50 selbst und zu der benachbarten Durchkontaktierung eines anderen Leiters 3,4,5 schmelzen und zum Teil verdampfen. Durch den dadurch entstehenden Druck wird der isolierende Lagenaufbau der Leiterplatte 2 im Inneren partiell zwischen den betroffenen Phasen zerstört. Im Kurzschlussfall wird die isolierenden Eigenschaften der Leiterplatte 2 durch das Aufschmelzen derart verringert, dass der Hilfsphasenkurzschluss möglich wird.

Somit entsteht nahe der Eingangsklemme ein Hilfskurzschlussstrompfad 17, der zum Auslösen des vorgelagerten Leitungsschutzschalters führt. Der durch die Vorrichtung 1 zu den Ausgangsklemmen fließende ursprüngliche Kurzschlussstrom wird so erheblich reduziert. Dadurch ergeben sich beim Leiterplattendesign zusätzliche Freiheitsgrade, da nun der Strom hinter dem Hilfskurzschlussbereich (den Verjüngungen 30,40,50) z.B. wieder auf Außenbahnen der Leiterplatte geführt werden kann, ohne befürchten zu müssen, dass diese im Kurzschlussfall verdampfen mit der Folge der Lichtbogenbildung und Zerstörung der Vorrichtung.

Als Vorteil erweist es sich, die Verjüngungen neben Durchkontaktierungen 18 von THT- Bauteilen vorbeizuführen, da hierdurch die einzelnen Lagen der Leiterplatte 2 besser zusammen gehalten werden und das Aufblähen durch das Verdampfen der Leiterbahnengstellen zwischen den betroffenen Verjüngungen 30,40,50 auf einen kleineren Bereich beschränkt bleibt. Hierdurch können ferner die Auswirkungen des Kurzschlusses am Eingang der Vorrichtung 1 minimiert werden.

Ebenso von Vorteil ist es, die Verjüngungen 30,40,50 im Nahbereich von Durchkontaktierungen 18 oder Durchführungen von THT-Bauteilen anderer Phasen verlaufen zu lassen. Dadurch entsteht im Kurzschlussfall der Hilfskurzschlussstrompfad 17 schneller. Der Kurzschluss kann schneller abgeschaltet werden und erzeugt geringere Veränderungen im betroffenen Leiterplattenbereich.

Das Führen der jeweiligen Verjüngung 30,40,50 der Leiterbahn 32,42,52 in den Innenlagen der Leiterplatte 2 hat den Vorteil, dass am eingangsseitigen Anschluss 6 der Leiterplatte 2 die Auswirkungen des provozierten Hilfskurzschlusses vermindert werden, da der Kurzschluss in den Innenlagen der Leiterplatte 2 und nicht außen entsteht.

Um auch ein- oder zweiphasige Kurzschlüsse zu beherrschen, müssen alle Phasen die im Hauptstromkreis vorkommen, untereinander kombiniert werden.

Durch die gezielte Verlagerung des Kurzschlusses in einen definierten Bereich der Vorrichtung 1 kann ein zusätzlicher Hilfskurzschlussstrompfad 17 an den Verjüngungen der Leiter 3,4,5 erzeugt werden, so dass der Kurzschlussstrom nicht mehr durch die ganze Vorrichtung 1 fließt. Dadurch sind die Auswirkungen des Kurzschlussstromes in der Vorrichtung 1 geringer. Durch die verringerte Lichtbogenbildung in der Vorrichtung 1 wird die Wahrscheinlichkeit eines Überschlags zu anderen Stromkreisen verringert. Eine höhere Kurzschlussfestigkeit wird hierdurch erreicht, so dass die Vorrichtung 1 für höhere prospektive Kurzschlussströme eingesetzt werden kann.

Das Bauvolumen der Vorrichtung 1 kann ferner reduziert werden, da z.B. eine Kapselung der Vorrichtung 1 verringert werden oder entfallen kann.

Es versteht sich von selbst, dass der Motorstarter 1 ebenso eine Vorrichtung sein kann, welche aktiv den Strom für den nachgeschalteten Verbraucher 14 beeinflussen kann.

## Patentansprüche

1. Vorrichtung (1) zum Anschließen an ein Stromnetz (10), mit einer Leiterplatte (2), einer ersten eingangsseitigen Anschlussstelle (21), an welche eine erste Phase (11) des Stromnetzes (10) anschließbar ist, einer zweiten eingangsseitigen Anschlussstelle (22), an welche eine zweite Phase (12) des Stromnetzes (10) anschließbar ist, und einem ersten und zweiten elektrischen Leiter (3,4), wobei der erste Leiter (3) mit der ersten eingangsseitigen Anschlussstelle (21) und der zweite Leiter (4) mit der zweiten eingangsseitigen Anschlussstelle (22) geräteintern verbunden ist,
**dadurch gekennzeichnet, dass**
der erste Leiter (3) als Leiterbahn (32) in einer Innenlage der Leiterplatte (2) geführt ist und dort eine Verjüngung (30) aufweist, wobei die Verjüngung (30) derart ausgebildet ist und der zweite Leiter (4) derart an der Verjüngung (30) des ersten Leiters (3) vorbeigeführt ist, dass eine zwischen der Verjüngung (30) des ersten Leiters (3) und dem zweiten Leiter (4) vorliegende elektrische Isolation bei einem Kurzschlussstrom über den ersten Leiter (3) zerstört wird, so dass eine elektrisch leitende Verbindung zwischen dem ersten und zweiten Leiter (3,4) vorliegt.

2. Vorrichtung (1) nach Anspruch 1, wobei die Vorrichtung (1) eine erste und eine zweite ausgangsseitige Anschlussstelle (24,25) aufweist, wobei der erste Leiter (3) eine geräteinterne elektrische Verbindung zwischen der ersten eingangsseitigen Anschlussstelle (21) und der ersten ausgangsseitigen Anschlussstelle (24) herstellt und der zweite Leiter (4) eine geräteinterne elektrische Verbindung zwischen der zweiten eingangsseitigen Anschlussstelle (22) und der zweiten ausgangsseitigen Anschlussstelle (25) herstellt.

3. Vorrichtung (1) nach einem der vorhergehenden Ansprüche, wobei der erste Leiter (3) ein Schaltelement (9) umfasst.

4. Vorrichtung (1) nach Anspruch 3, wobei sich die Verjüngung (30) des ersten Leiters (3) zwischen der ersten Anschlussstelle (21) und dem Schaltelement (9) befindet.

5. Vorrichtung (1) nach einem der vorhergehenden Ansprüche, wobei sich die Verjüngung (30) des ersten Leiters (3) im Bereich der ersten 20 Prozent der gesamten Länge des ersten Leiters (3) auf der Leiterplatte (2) befindet.

6. Vorrichtung (1) nach einem der vorhergehenden Ansprüche, wobei die Verjüngung (30) des ersten Leiters (3) eine Länge von maximal 5 Prozent der gesamten Länge des ersten Leiters (3) auf der Leiterplatte (2) aufweist.

7. Vorrichtung (1) nach einem der vorhergehenden Ansprüche, wobei der zweite Leiter (4) über eine Durchkontaktierung (18) der Leiterplatte (2) an der Verjüngung (30) des ersten Leiters (3) vorbeigeführt ist.

8. Vorrichtung (1) nach einem der vorhergehenden Ansprüche, wobei der erste Leiter (3) aufgeteilt ist, so dass zwei Verjüngungen (30) des ersten Leiters (3) vorliegen.

9. Vorrichtung (1) nach einem der vorhergehenden Ansprüche, wobei die Vorrichtung (1) eine dritte eingangsseitige Anschlussstelle (23), an welche eine dritte Phase (13) eines Stromnetzes (10) anschließbar ist, und einen dritten elektrischen Leiter (5) umfasst, wobei der dritte Leiter (5) mit der dritten eingangsseitigen Anschlussstelle (23) geräteintern verbunden ist, wobei der dritte Leiter (5) als Leiterbahn (52) in der Innenlage der Leiterplatte (2) geführt ist und dort eine Verjüngung (50) aufweist, wobei die Verjüngung (50) des dritten Leiters (5) derart ausgebildet ist und der zweite und/oder erste Leiter (3,5) derart an der Verjüngung (50) des dritten Leiters (5) vorbeigeführt ist, dass eine zwischen der Verjüngung (50) des dritten Leiters (5) und dem zweiten und/oder ersten Leiter (3,4) vorliegende elektrische Isolation bei einem Kurzschlussstrom über den dritten Leiter (5) zerstört wird, so dass eine elektrisch leitende Verbindung zwischen dem dritten Leiter (5) und ersten und/oder zweiten Leiter (3,4) vorliegt.

10. Vorrichtung (1) nach Anspruch 9, wobei der zweite Leiter (4) über dieselbe Durchkontaktierung (18) der Leiterplatte (2) an der Verjüngung (30,50) des ersten und dritten Leiters (3,5) vorbeigeführt ist.

11. Vorrichtung (1) nach Anspruch 9 oder 10, wobei der dritte Leiter (5) an der Verjüngung (30) des ersten Leiters (3) oder einer weiteren Verjüngung (30) des ersten Leiters (3) in einer Innenlage der Leiterplatte (2) derart vorbeigeführt ist, dass eine zwischen der Verjüngung (30) bzw. weiteren Verjüngung (30) des ersten Leiters (3) und dem dritten Leiter (5) vorliegende elektrische Isolation bei einem Kurzschlussstrom über den ersten Leiter (3) zerstört wird, so dass eine elektrisch leitende Verbindung zwischen dem ersten und dritten Leiter (3,5) vorliegt.

12. Vorrichtung (1) nach einem der Ansprüche 9 bis 11, wobei der dritte Leiter (5) in der Innenlage der Leiterplatte (2) eine weitere Verjüngung (50) aufweist, wobei die weitere Verjüngung (50) des dritten Leiters (5) derart ausgebildet ist und der erste Leiter (3) derart an der weiteren Verjüngung (50) des dritten Leiters (5) vorbeigeführt ist, dass eine zwischen der weiteren Verjüngung (50) des dritten Leiters (5) und dem zweiten oder ersten Leiter (3,4) vorliegende elektrische Isolation bei einem Kurzschlussstrom über den dritten Leiter (5) zerstört wird, so dass eine elektrisch leitende Verbindung zwischen dem dritten Leiter (5) und zweiten oder ersten Leiter (3,4) vorliegt.

13. Vorrichtung (1) nach einem der vorhergehenden Ansprüche, wobei der zweite Leiter (4) als Leiterbahn (40) in der Innenlage der Leiterplatte (2) geführt ist und dort eine Verjüngung (40) aufweist, wobei die Verjüngung (40) des zweiten Leiters (4) derart ausgebildet ist und der erste Leiter (3) derart an der Verjüngung (40) des zweiten Leiters (4) vorbeigeführt ist, dass eine zwischen der Verjüngung (40) des zweiten Leiters (4) und dem ersten Leiter (3) vorliegende elektrische Isolation bei einem Kurzschlussstrom über den zweiten Leiter (4) zerstört wird, so dass eine elektrisch leitende Verbindung zwischen dem zweiten und ersten Leiter (3,4) vorliegt.

14. System mit einer Vorrichtung (1) nach einem der Ansprüche 1 bis 13, einer Überstromschutzeinrichtung (15), einem elektrischen Verbraucher (14) und einem Stromnetz (10) einer industriellen Anlage, wobei das Stromnetz (10) über die Überstromschutzeinrichtung (15) und der der Überstromschutzeinrichtung (15) nachgeschalteten Vorrichtung (1) mit dem elektrischen Verbraucher (14) verbunden ist.

15. Verfahren zum Schutz einer Vorrichtung (1) nach einem der Ansprüche 1 bis 13, wobei der zweite Leiter (4) zur Verjüngung (30) des ersten Leiters (3) elektrisch isoliert ist und bei einem Kurzschlussstrom über den ersten Leiter (3) eine zwischen der Verjüngung (30) des ersten Leiters (3) und dem zweiten Leiter (4) vorliegende elektrische Isolation zerstört wird, so dass eine elektrisch leitende Verbindung zwischen dem ersten und zweiten Leiter (3,4) vorliegt.

## Claims

1. Device (1) for connecting to a power network (10), having a circuit board (2), a first input-side connection point (21), to which a first phase (11) of the power network (10) can be connected, a second input-side connection point (22), to which a second phase (12) of the power network (10) can be connected, and a first and a second electrical conductor (3, 4), wherein the first conductor (3) is connected to the first input-side connection point (21) and the second conductor (4) is connected to the second input-side connection point (22) inside the device,
**characterised in that**
the first conductor (3) is routed as a conductor trace (32) in an interior layer of the circuit board (2) and has a constriction (30) there, wherein the constriction (30) is formed and the second conductor (4) is routed past the constriction (30) in such a manner that electrical insulation existing between the constriction (30) of the first conductor (3) and the second conductor (4) is destroyed in the case of a short-circuit current via the first conductor (3), and therefore an electrically conductive connection between the first and second conductor (3, 4) exists.

2. Device (1) according to claim 1, wherein the device (1) comprises a first and a second output-side connection point (24,25), wherein the first conductor (3) produces an electrical connection inside the device between the first input-side connection point (21) and the first output-side connection point (24), and the second conductor (4) produces an electrical connection inside the device between the second input-side connection point (22) and the second output connection point (25).

3. Device (1) according to one of the preceding claims, wherein the first conductor (3) comprises a switching element (9).

4. Device (1) according to claim 3, wherein the constriction (30) of the first conductor (3) is located between the first connection point (21) and the switching element (9).

5. Device (1) according to one of the preceding claims, wherein the constriction (30) of the first conductor (3) is located on the circuit board (2) in the region of the first 20 percent of the total length of the first conductor (3).

6. Device (1) according to one of the preceding claims, wherein the constriction (30) of the first conductor (3) has a length on the circuit board (2) of at most five percent of the total length of the first conductor (3).

7. Device (1) according to one of the preceding claims, wherein the second conductor (4) is routed past the constriction (30) of the first conductor (3) via a plated-through hole (18) of the circuit board (2).

8. Device (1) according to any one of the preceding claims, wherein the first conductor (3) is divided so two constrictions (30) of the first conductor (3) exist.

9. Device (1) according to one of the preceding claims, wherein the device (1) comprises a third input-side connection point (23), to which a third phase (13) of a power network (10) can be connected, and a third electrical conductor (5), wherein the third conductor (5) is connected to the third input-side connection point (23) inside the device, wherein the third conductor (5) is routed as a conductor trace (52) in the interior layer of the circuit board (2) and has a constriction (50) there, wherein the constriction (50) of the third conductor (5) is formed in such a manner and the second and/or first conductor (3,5) is routed past the constriction (50) of the third conductor (5) in such a manner that electrical insulation existing between the constriction (50) of the third conductor (5) and the second and/or first conductor (3,4) is destroyed in the case of a short-circuit current via the third conductor (5), and therefore an electrically conductive connection between the third conductor (5) and first and/or second conductor (3,4) exists.

10. Device (1) according to claim 9, wherein the second conductor (4) is routed past the constriction (30,50) of the first and third conductors (3,5) via the same plated-through hole (18) of the circuit board (2).

11. Device (1) according to claim 9 or 10, wherein the third conductor (5) is routed past the constriction (30) of the first conductor (3) or a further constriction (30) of the first conductor (3) in an interior layer of the circuit board (2) in such a manner that electrical insulation existing between the constriction (30) or further constriction (30) of the first conductor (3) and the third conductor (5) is destroyed in the case of a short-circuit current via the first conductor (3), and therefore an electrically conductive connection between the first and third conductors (3,5) exists.

12. Device (1) according to one of claims 9 to 11, wherein the third conductor (5) in the interior layer of the circuit board (2) comprises a further constriction (50), wherein the further constriction (50) of the third conductor (5) is formed in such a manner and the first conductor (3) is routed past the further constriction (50) of the third conductor (5) in such a manner that electrical insulation existing between the further constriction (50) of the third conductor (5) and the second or first conductor (3, 4) is destroyed in the case of a short-circuit current via the third conductor (5), and therefore an electrically conductive connection between the third conductor (5) and the second or the first conductor (3,4) exists.

13. Device (1) according to one of the preceding claims, wherein the second conductor (4) is routed as a conductor trace (40) in the interior layer of the circuit board (2) and has a constriction (40) there, wherein the constriction (40) of the second conductor (4) is formed and the first conductor (3) is routed past the constriction (40) of the second conductor (4) in such a manner that electrical insulation existing between the constriction (40) of the second conductor (4) and the first conductor (3) is destroyed in the case of a short-circuit current via the second conductor (4), and therefore an electrically conductive connection between the second and first conductors (3,4) exists.

14. System having a device (1) according to one of claims 1 to 13, an overcurrent protective device (15), an electrical load (14) and a power network (10) of an industrial plant, wherein the power network (10) is connected by the overcurrent protective device (15) and the device (1) connected downstream of the overcurrent protective device (15) to the electrical load (14).

15. Method for protecting a device (1) according to any one of claims 1 to 13, wherein the second conductor (4) is electrically insulated from the constriction (30) of the first conductor (3) and electrical insulation existing between the constriction (30) of the first conductor (3) and the second conductor (4) is destroyed in the case of a short-circuit current via the first conductor (3), and therefore an electrically conductive connection between the first and second conductors (3, 4) exists.

## Revendications

1. Dispositif de connexion à un réseau (10) électrique comprenant une plaquette (2) à circuit imprimé, un premier point (21) de connexion du côté de l'entrée, auquel une première phase (11) du réseau (10) électrique peut être connectée, un deuxième point (22) de connexion du côté de l'entrée, auquel une deuxième phase (12) du réseau (10) électrique peut être connectée, et un premier et deuxième conducteurs (3, 4) électriques, le premier conducteur (3) étant relié d'une manière interne à l'appareil au premier point (21) de connexion du côté de l'entrée et le deuxième conducteur (4) au deuxième point (22) de connexion du côté de l'entrée,
**caractérisé en ce que**
le premier conducteur (3) passe sous la forme d'une piste (32) conductrice dans une couche intérieure de la plaquette (2) à circuit imprimé et y a un réduction (30), la réduction (30) étant constituée et le deuxième conducteur (4) passant devant la réduction du premier conducteur (3) de manière à détruire, s'il se produit un courant de court-circuit aux bornes du premier conducteur (3), une isolation électrique présente entre la réduction (30) du premier conducteur (3) et le deuxième conducteur (4), de manière à avoir une liaison conductrice de l'électricité entre le premier et le deuxième conducteur (3, 4).

2. Dispositif (1) suivant la revendication 1, dans lequel le dispositif (1) a un premier et un deuxième points (24, 25) de connexion du côté de la sortie, le premier conducteur (3) ménageant une liaison électrique interne à l'appareil entre le premier point (21) de connexion du côté de l'entrée et le premier point (24) de connexion du côté de la sortie et le deuxième conducteur (4) une liaison électrique interne à l'appareil entre le deuxième point (22) de connexion du côté de l'entrée et le deuxième point (25) de connexion du côté de la sortie.

3. Dispositif (1) suivant l'une des revendications précédentes dans lequel le premier conducteur (3) comprend un élément (9) de commutation.

4. Dispositif (1) suivant l'une des revendications précédentes, dans lequel la réduction (30) du premier conducteur (3) se trouve entre le premier point (21) de connexion et l'élément (9) de commutation.

5. Dispositif (1) suivant l'une des revendications précédentes, dans lequel la réduction (30) du premier conducteur (3) se trouve dans la région des premiers 20 % de toute la longueur du premier conducteur (3) sur la plaquette (2) à circuit imprimé.

6. Dispositif (1) suivant l'une des revendications précédentes, dans lequel la réduction (30) du premier conducteur (3) a une longueur représentant au maximum 5 % de toute la longueur du premier conducteur (3) sur la plaquette (2) à circuit imprimé.

7. Dispositif (1) suivant l'une des revendications précédentes, dans lequel la deuxième conducteur (4) passe devant le réduction (30) du premier conducteur (3) sur une connexion (18) de la plaquette (2) à circuit imprimé.

8. Dispositif (1) suivant l'une des revendications précédentes, dans lequel le premier conducteur (3) est subdivisé de manière à avoir deux réductions (30) du premier conducteur (3).

9. Dispositif (1) suivant l'une des revendications précédentes, dans lequel le dispositif (1) comprend un troisième point (23) de connexion du côté de l'entrée, auquel une troisième phase (13) d'un réseau (10) électrique peut être connectée et un troisième conducteur (5) électrique, le troisième conducteur (5) étant relié d'une manière interne à l'appareil au troisième point (23) de connexion du côté de l'entrée, le troisième conducteur (5) passant sous la forme d'une piste (52) conductrice dans la couche intérieure de la plaquette (2) à circuit imprimé et y ayant une réduction (50), la réduction (50) du troisième conducteur (5) étant constituée et le deuxième et/ou le premier conducteur (3, 5) passant devant la réduction (50) du troisième conducteur (5) de manière à détruire, s'il se produit un courant de court-circuit aux bornes du troisième conducteur (5), une isolation électrique présente entre la réduction (50) du troisième conducteur (5) et le deuxième et/ou le premier conducteur (3, 4), de manière à avoir une liaison conductrice de l'électricité entre le troisième conducteur (5) et le premier et/ou le deuxième conducteur (3, 4).

10. Dispositif (1) suivant la revendication 9, dans lequel le deuxième conducteur (4) passe devant la réduction (30, 50) du premier et du troisième conducteurs (3, 5) sur la même connexion (18) de la plaquette (2) à circuit imprimé.

11. Dispositif (1) suivant la revendication 9 ou 10, dans lequel le troisième conducteur (5) passe devant la réduction (30) du premier conducteur (3) ou une autre réduction (30) du premier conducteur (3) dans une couche intérieure de la plaquette (2) à circuit imprimé, de manière à détruire, s'il se produit un courant de court-circuit aux bornes du premier conducteur (3), une isolation électrique présente entre la réduction (30) ou l'autre réduction (30) du premier conducteur (3) et le troisième conducteur (5), de manière à avoir une liaison conductrice de l'électricité entre le premier et le troisième conducteurs (3, 5).

12. Dispositif (1) suivant l'une des revendications 9 à 11, dans lequel le troisième conducteur (5) a une autre réduction (50) dans la couche intérieure de la plaquette (2) à circuit imprimé, l'autre réduction (50) du troisième conducteur (5) étant constituée et le premier conducteur passant devant l'autre réduction (50) du troisième conducteur (5) de manière à détruire, s'il se produit un courant de court-circuit aux bornes du troisième conducteur (5), une isolation électrique présente entre l'autre réduction (50) du troisième conducteur (5) et le deuxième ou le premier conducteur (3, 4) de manière à avoir une liaison conductrice de l'électricité entre le troisième conducteur (5) et le deuxième ou le premier conducteur (3, 4).

13. Dispositif (1) suivant l'une des revendications précédentes, dans lequel le deuxième conducteur (4) passe sous la forme d'une piste (40) conductrice dans la couche intérieure de la plaquette (2) à circuit imprimé et y a une réduction, la réduction (40) du deuxième conducteur (4) étant constituée et le premier conducteur (3) passant devant la réduction (40) du deuxième conducteur (4) de manière à détruire, s'il se produit un courant de court-circuit aux bornes du deuxième conducteur (4), une isolation électrique présente entre la réduction (40) du deuxième conducteur (4) et le premier conducteur (3), de manière à avoir une liaison conductrice de l'électricité entre le deuxième et le premier conducteurs (3, 4).

14. Système comprenant un dispositif (1) suivant l'une des revendications 1 à 13, un dispositif (15) de protection vis-à-vis d'une surintensité, un consommateur (14) électrique et un réseau (10) électrique d'une installation industrielle, le réseau (10) électrique étant relié au consommateur (14) électrique par le dispositif (15) de protection vis-à-vis d'une surintensité et par le dispositif (1) monté en aval du dispositif (15) de protection vis-à-vis d'une surintensité.

15. Procédé de protection d'un dispositif (1) suivant l'une des revendications 1 à 13, le deuxième conducteur (4) étant pour la réduction (30) du premier conducteur (3) isolé électriquement et, s'il se produit un courant de court-circuit aux bornes du deuxième conducteur (3), une isolation électrique présente entre la réduction (30) du premier conducteur (3) et le deuxième conducteur (4) étant détruite de manière à avoir une liaison conductrice de l'électricité entre le premier et le deuxième conducteurs (3, 4).
